## Europäisches Patentamt
## European Patent Office
## Office européen des brevets

(11) Publication number: **0 121 507**
**A1**

# (12) EUROPEAN PATENT APPLICATION

(21) Application number: **84850070.8**

(22) Date of filing: **06.03.84**

(51) Int. Cl.³: **G 01 R 19/155**

(30) Priority: **08.03.83 SE 8301252**

(43) Date of publication of application:
**10.10.84 Bulletin 84/41**

(84) Designated Contracting States:
**AT BE CH DE FR GB IT LI NL**

(71) Applicant: **Jonsson, Knut**
**Hov 469**
**S-820 11 Vallsta(SE)**

(71) Applicant: **Svahn, Olle**
**Östansjö 1558**
**S-820 11 Vallsta(SE)**

(72) Inventor: **Gullbrand, Sune**
**Box 520**
**S-820 42 Korskrogen(SE)**

(74) Representative: **Berglund, Gustav Arthur et al,**
**AWAPATENT AB Box 5117**
**S-200 71 Malmö(SE)**

(54) Single-pole voltage tester.

(57) A single-pole voltage tester comprises an electrically conductive test prod (1) adapted to be connected, via one or more high-ohmic resistors (2) built into a non-conductive or insulating casing (7), to the operator's body, preferably his hand, thereby to provide, upon connection of the test prod to an assumed live point, a connection to the operator's capacitance and thus a current through the resistors which is directly or indirectly utilised for activating an indicator (5), the connection between the operator (8) and the test prod (1) — upon voltage testing — being established exclusively non-galvanically, capacitatively and/or inductively through the insulating casing (7) of the tester. In order to make self-checking as well as ohmic testing of optional test pieces possible, the tester is provided with a reference contact member (12), such as a metal pin which is connected to the test prod (1) via an amplifier (3, 3') of such polarity that current passes through the resistors (2), and the indicator (5) is activated upon galvanic contact between the test prod (1) and the reference contact member (12).

Fig 1

EP 0 121 507 A1

## SINGLE-POLE VOLTAGE TESTER

Background of the invention

The present invention relates to a single-pole voltage tester comprising an electrically conductive test prod adapted to be connected, via one or more high-ohmic resistors built into a non-conductive or insulating casing, to the operator's body, preferably his hand, thereby to provide, upon connection of the test prod to an assumed live point, such as a measuring terminal, a connection to the operator's capacitance and thus a current through the resistors which is directly or indirectly utilised for activating an indicator, such as a light-emitting diode, lamp or the like, the connection between the operator and the test prod - upon voltage testing - being established exclusively non-galvanically, capacitatively and/or inductively through the insulating casing of the tester.

Prior art

A voltage tester of the above type is already known from FR patent specification 7930818. However, this tester has no self-checking means to check whether the tester itself is operational, for which reason the practical usefulness of this tester is extremely limited.

Brief description of the invention

The present invention aims at obviating the shortcomings of prior art single-pole type voltage testers and to provide a highly versatile tester. According to the principle of the invention, this is achieved in that the tester - in order to make self-checking as well as ohmic testing of optional test pieces possible - is provided with a reference contact member, such as a metal pin which is connected to the test prod via an amplifier of such polarity that current passes through the resistors, and the indicator is activated upon galvanic contact between the test prod and the reference contact member.

Brief description of the drawing

In the accompanying drawing

Fig. 1 is a diagram illustrating the electrical functions of the tester according to the invention; and

Fig. 2 is a simplified perspective view of the mechanical design of the tester.

Detailed description of an embodiment of the invention chosen by way of example

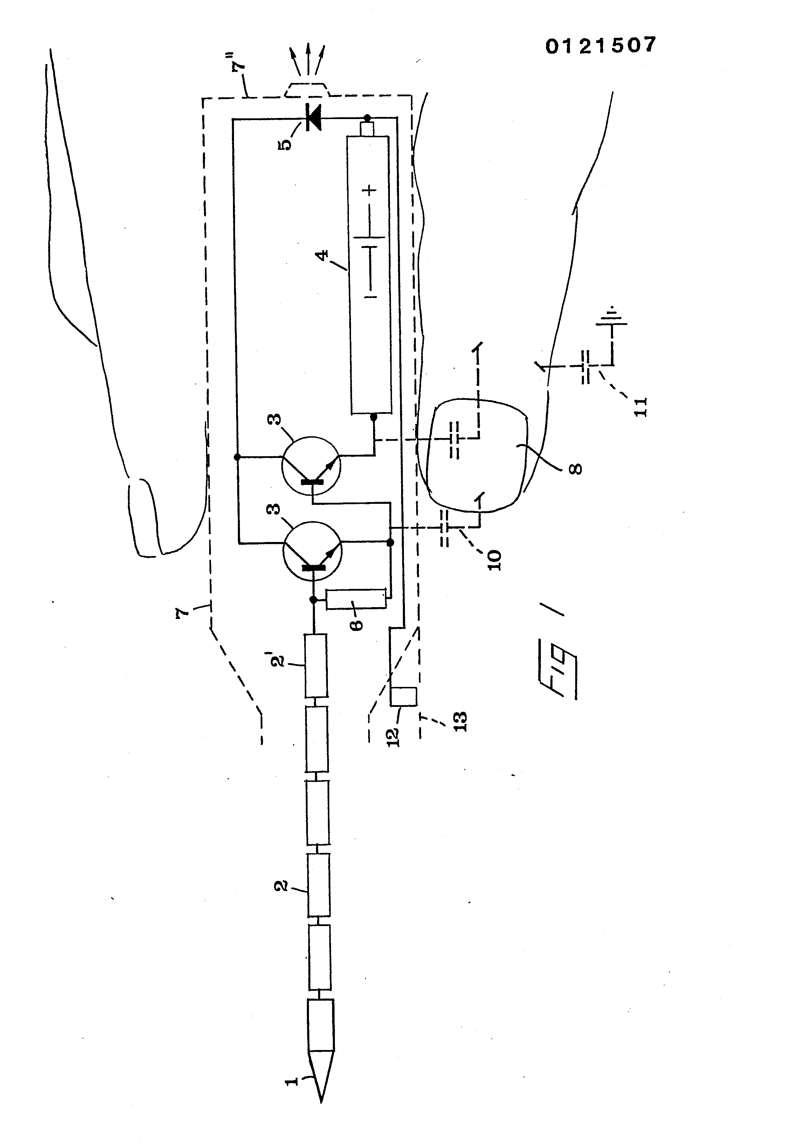

In Fig. 1 a test prod 1 is conductively connected to a number of series-connected resistors 2. Although the number of these resistors theoretically may vary between a single and a multiplicity of resistors, five resistors of each 3.2 Mohm, i.e. a total of 16 Mohm, are preferred in the embodiment illustrated. The last resistor 2' in the resistor chain extending from the test prod 1 is connected to the base of a first transistor 3 which, in its turn, is connected to a second transistor 3', thereby forming a Darlington circuit in order to obtain high-current gain. If it is assumed that each individual transistor amplifies the current 150 times, the Darlington circuit illustrated gives a total gain of about 22,500 times. The circuit illustrated also includes a current source in the form of a battery 4, a light-emitting diode 5 and a further resistor 6 which serves to impart to the tester a suitable sensitivity in that part of the current through the resistors 2 will pass both through the resistor 6 and into the base of the transistor 3. It will be evident that it is the current portion passing through the transistor 3 which is amplified in the Darlington circuit and, where appropriate, activates the light-emitting diode 6.

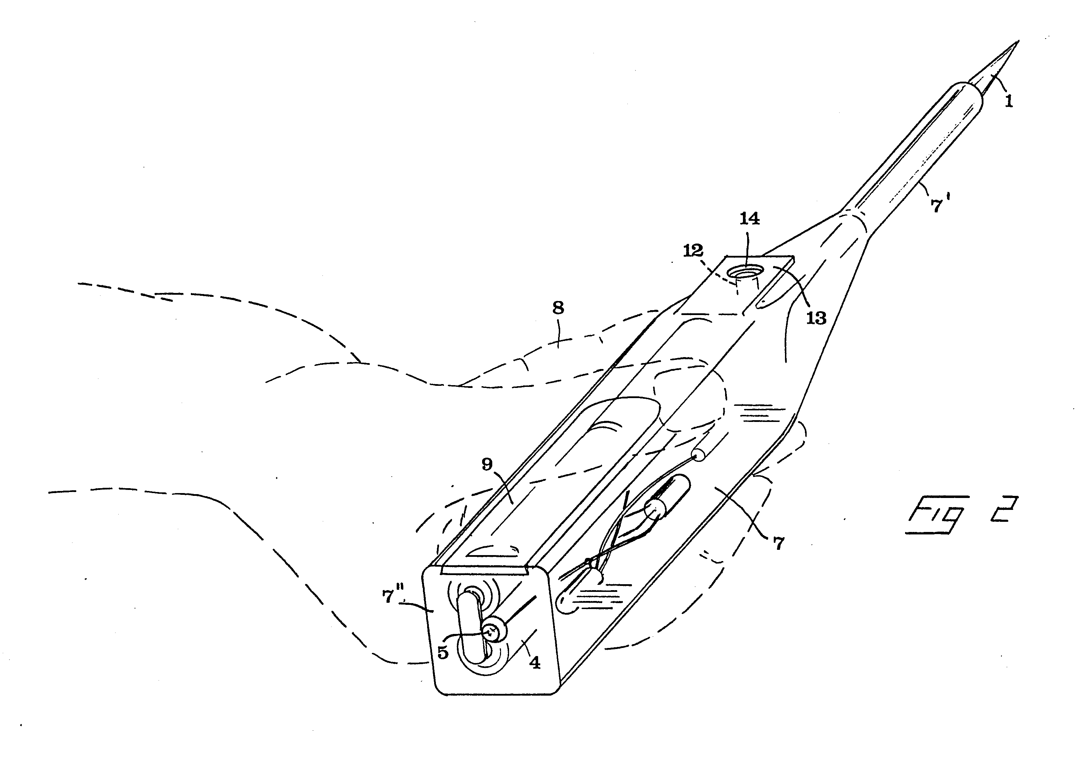

In the drawing, 7 is a casing, the main part of which is formed as an easy-to-grasp handle which at one end merges into a tapered portion 7' at the free end of which the test prod 1 is mounted. The tapered portion consists of an electrically non-conductive material which, in actual practice, is made of dimensionally stable plastic. It should be noted that all of the components which are illustrated in Fig. 1 and which are in the form of resistors, transistors, battery, light-emitting diode and conductors (except for the test prod 1) are completely enclosed within the casing 7 so that they cannot be touched by the operator who in the drawing is represented by the hand 8. To facilitate exchange of batteries, the casing 7 is provided with a removable lid 9. For voltage testing, the test prod 1 is connected to the point, such as a voltage terminal, which is to be checked, the operator holding the voltage tester in his hand in conventional manner, for instance as illustrated in Fig. 2. If the voltage at the said point is an alternating voltage, a circuit is closed from the test prod 1 via the resistors 2, 6, the transistors 3, 3' and the capacitative circuit 10 (see Fig. 1) between the tester and the operator 8 to the circuit 11 between the operator and earth, which also is a capacitative circuit. The current generated in the said circuit is amplified by the transistors 3, 3' and then lights up the light-emitting diode 5 which serves as an indicator.

A person skilled in the art can readily try out different characteristics of the components comprised by the voltage tester to obtain maximum efficiency. Also the location of the components within the casing is of importance to the function of the voltage tester. For instance, the battery or batteries 4 should be located as closely as possible to the end wall 7" of the casing to achieve maximum capacitance.

Although the voltage tester according to the invention is intended primarily for voltage testing, as has been described above, it may also be used for ohmic testing and self-checking. To this end, there is provided in the circuit according to Fig. 1 a reference contact 12 in the form of a metallic pin connected to the positive terminal of the battery 4 (see also Fig. 2). Normally, during voltage testing, this contact pin is concealed in some suitable manner to prevent the operator from touching it inadvertently. In the embodiment illustrated, the pin is concealed under a resilient or spring-loaded tongue 13 having a hole 14, the shape and location of which correspond to the shape and location of the pin 12. By depressing the tongue 13, the pin can be exposed intentionally and brought into contact with, for example, a finger of the operator's hand.

When the voltage tester is used for ohmic testing or power failure testing, the prod 1 is connected to the test piece, such as a fuse, a light bulb or the like, and the operator puts his finger on the pin 12. If no interruption of current has occurred in the test piece, a weak current will then pass from the pin via the operator, the test piece, the prod 1 and the resistors 2 to the transistors 3, 3', and after amplification in the transistors this current causes the light-emitting diode 5 to be illuminated, thereby indicating that the test piece is free from defects.

For self-checking, the operator can put one finger on the contact pin 12 and another finger on the test prod 1, which enables him, entirely without other tools or measuring devices, to check the function of the tester. The tester then functions as an ohmic meter, with the operator's body as the test piece, or in accordance with the principle of ohmic measuring as described above.

It should also briefly be said that the tester according to the invention may also be used for testing semi-conductors, such as diodes. The basic principle is the same as for the simple ohmic measuring as indicated above. By turning the diode around, the forward and reverse directions of the diode can be determined since the tester indicates upon measurement

5

in the forward direction of the diode. If no indication is obtained in any direction of the diode, there is a rupture in the diode. If the tester indicates in both directions, a break-down has occurred in the diode. In analogy therewith, the tester may be used for testing transistors (of the small signal type) and capacitors. It may also be used for fault finding in direct current circuits.

Possible modifications of the invention

It will be appreciated that the invention is not restricted to the embodiment described above and illustrated in the drawing. Thus, it is possible to use, instead of transistors in Darlington circuits, other components for the requisite current gain, and furthermore the number of resistors and their characteristics may deviate from the embodiment illustrated. The indicator need not be a light-emitting diode, and a lamp or the like may also be used. Furthermore, the reference contact 12 which, when necessary, is exposable, could be concealed in some other manner than by means of a resilient tongue, for instance by means of a rotatable or displaceable lid.

## CLAIMS

1. A single-pole voltage tester comprising an electrically conductive test prod (1) adapted to be connected, via one or more high-ohmic resistors (2) built into a non-conductive or insulating casing (7), to the operator's body, preferably his hand, thereby to provide, upon connection of the test prod to an assumed live point, such as a measuring terminal, a connection to the operator's capacitance and thus a current through the resistors which is directly or indirectly utilised for activating an indicator (5), such as a light-emitting diode, lamp or the like, the connection between the operator (8) and the test prod (1) - upon voltage testing - being established exclusively non-galvanically, capacitatively and/or inductively through the insulating casing (7) of the tester, c h a r a c t e r i s e d in that the tester - in order to make self-checking as well as ohmic testing of optional test pieces possible - is provided with a reference contact member (12), such as a metal pin which is connected to the test prod (1) via an amplifier (3, 3') of such polarity that current passes through the resistors (2), and the indicator (5) is activated upon galvanic contact between the test prod (1) and the reference contact member (12).

2. A voltage tester as claimed in claim 1, c h a - r a c t e r i s e d in that the current through the resistors (2) can pass in one direction only through the test prod (1), whereby PN junctions, for instance in diodes and transistors, can be checked.

3. A voltage tester as claimed in claim 1 or 2, c h a r a c t e r i s e d in that the reference contact member (12), when the tester is used for voltage testing, is concealed by means of a protective member (13) that can be moved aside in order to expose said contact member when the tester is used for ohmic testing and/or self-checking.

0121507

Fig 1

Fig 2

0121507

**0 1 2 1 5 0 7**
Application number

European Patent
Office

**EUROPEAN SEARCH REPORT**

EP 84 85 0070

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-4 205 268 (C. GOLD)<br>* Complete document * | 1-3 | G 01 R 19/155 |
| | --- | | |
| A | DE-A-3 004 734 (SIEMENS AG)<br><br>* Figure 1 * | | |
| | ----- | | |

**TECHNICAL FIELDS SEARCHED (Int. Cl. ³)**

G 01 R 19/145
G 01 R 19/155

The present search report has been drawn up for all claims

| Place of search | Date of completion of the search | Examiner |
|---|---|---|
| BERLIN | 24-05-1984 | LEMMERICH J |